# EUROPÄISCHE PATENTSCHRIFT

(11) **EP 0 515 376 B1**
(45) Veröffentlichungstag und Bekanntmachung des Hinweises auf die Patenterteilung: **17.08.1994**
(21) Anmeldenummer: 91900788.0
(22) Anmeldetag: 04.12.1990
(51) Int. Cl.: H04J 3/07, H03L 7/093

(54) **VERFAHREN UND ANORDNUNG ZUR TAKTRÜCKGEWINNUNG**
PROCESS AND DEVICE FOR BEAT RECOVERY
PROCEDE ET DISPOSITIF DE RECUPERATION DU RYTHME

(30) Priorität: 16.02.1990 EP 90103071
(43) Veröffentlichungstag der Anmeldung: 02.12.1992
(73) Patentinhaber: SIEMENS AKTIENGESELLSCHAFT, 80333 München (DE)
(72) Erfinder: VOLEJNIK, Wilhelm, D-8029 Sauerlach (DE)
(86) Internationale Anmeldenummer: EP9002090
(87) Internationale Veröffentlichungsnummer: WO9112678

(56) Entgegenhaltungen:
- EP-A- 0 084 675
- CH-A- 536 046
- US-A- 4 019 143
- US-A- 4 563 657
- US-A- 4 709 170

## Beschreibung

Die Erfindung bezieht sich auf ein Verfahren zur Taktrückgewinnung, bei dem die Phase eines Eingangstaktes mit der eines Ausgangstaktes verglichen wird und bei dem die Frequenz des Ausgangstaktes in Abhängigkeit vom Vergleichsergebnis mit Hilfe einer Korrekturgröße nachgezogen wird, sowie auf eine Anordnung zur Durchführung dieses Verfahrens.

Ein derartiges Verfahren ist aus dem Buch "Theorie und Anwendungen des Phase-locked Loops", Best, 4. überarbeitete Auflage, AT Verlag Aarau, Stuttgart, 1987, Seiten 93 bis 95 bekannt.

Eine Taktrückgewinnungseinrichtung mit einer Phasenregelschleife, bei der aus der Frequenz eines Quarzoszillators eine Folge in der Phase verschobener interner Takte abgeleitet wird, von denen, gesteuert durch die Ausgangssignale eines Phasendiskriminators, jeweils einer nach einer Frequenzteilung als Auslesetakt dient, ist Gegenstand eines älteren Vorschlags (DE-A-3 909 678 09 678.5).

Aus der Druckschrift CH-A-0 536 046 ist eine Schaltungsanordnung zu entnehmen, die zur automatischen Einstellung eines Oszillators dient.

In der Technik des Übertragens und Multiplexens digitaler Signale erfolgt derzeit eine Umstellung von einem plesiochronen auf einen synchronen Betrieb. Während die herkömmlichen plesiochronen Signale eine Bit-Struktur haben, weisen die neuen synchronen Signale eine Byte-Struktur, d.h. eine Gliederung aus Vielfachen von acht Bits auf. Dies geht aus den CCITT-Empfehlungen G.707, G.708 und G.709 hervor. .

In der Multiplextechnik werden mehrere Digitalsignale durch Verschachteln zu einem Zeitmultiplexsignal zusammengefaßt. In der Synchron-Digital-Multiplexhierarchie erfolgt dies entsprechend der Byte-Struktur in Gruppen von jeweils acht Bits. Da die Phasen der zu verschachtelnden Digitalsignale häufig nicht starr zueinander sind, sondern in Abhängigkeit von der Vorgeschichte gegeneinander wandern, muß beim Verschachteln eine Phasenanpassung vorgeschaltet werden.

Die Phasenanpassung erfolgt durch Stopfen. Dabei werden in vorgegebenen diskreten Zeitpositionen (Zeitschlitzen) des abgehenden Multiplexsignals - in Abhängigkeit von der augenblicklichen Phase bzw. Frequenz des zu multiplexenden Signals relativ zum Multiplexsignal - entweder acht dem zu multiplexenden Signal zugeordnete Zeitschlitze mit dessen Daten gefüllt oder nicht. Beim Stopfen springt demnach die Phase des zu multiplexenden synchronen Signals relativ zum Multiplexsignal um acht UI (Unit Interval), bzw. um ein Byte (8 Bits).

Nach der Übertragung wird das Multiplexsignal wieder in seine einzelnen Komponenten aufgelöst. Eines der dabei auftretenden Probleme ist die Rückgewinnung der Originaltakte der gemultiplexten Signale, denn es müssen an die Gleichmäßigkeit dieser rückgewonnen Takte hohe Anforderungen gestellt werden.

In der zeitlichen Aufeinanderfolge der Taktflanken auftretende Unregelmäßigkeiten werden als Jitter bezeichnet. Da sich der in verschiedenen Übertragungsabschnitten erzeugte Jitter in deren Hintereinanderschaltung addiert, muß der durch einzelne Ursachen hervorgerufene Jitter eng begrenzt werden. Dies gilt auch für den, der durch stopfenbedingte Phasensprünge verursacht wird.

Eine Eigenheit der Übertragung digitaler Signale liegt darin, daß sehr langsam ablaufende Phasenschwankungen, der sogenannte Wander, von den Übertragungsgeräten gut vertragen werden. Seine zulässigen Grenzwerte sind daher wesentlich höher als die des Jitters.

Der Erfindung liegt die Aufgabe zugrunde, bei der Rückgewinnung des Originaltaktes des gemultiplexten Signals im Multiplexer den durch Stopfen erzeugten Jitter in Wander umzuwandeln.

Diese Aufgabe wird bei einem Verfahren der einleitend beschriebenen Art erfindungsgemäß dadurch gelöst, das sprunghafte Änderungen der Korrekturgröße unterdrückt werden. Anordnungen zur Durchführung dieses Verfahrens sind den Unteransprüchen zu entnehmen.

Anhand eines Ausführungsbeispiels wird die Erfindung nachstehend näher erläutert:
- Figur 1: zeigt ein Blockschaltbild einer bekannten Taktrückgewinnungseinrichtung,
- Figur 2: zeigt das Blockschaltbild der erfindungsgemäßen Taktrückgewinnungseinrichtung,
- Figur 3: zeigt einen älteren Vorschlag einer Taktrückgewinnungseinrichtung,
- Figur 4: zeigt erste Pulsdiagramme zur Erläuterung der Erfindung,
- Figur 5: zeigt zweite Pulsdiagramme zur Erläuterung der Erfindung,
- Figur 6: zeigt dritte Pulsdiagramme zur Erläuterung der Erfindung,
- Figuren 7+8: zeigen die erfindungsgemäße Taktrückgewinnungseinrichtung und
- Figur 9: zeigt ein Diagramm zur Erläuterung der Taktrückgewinnungseinrichtung nach den Figuren 7 und 8.

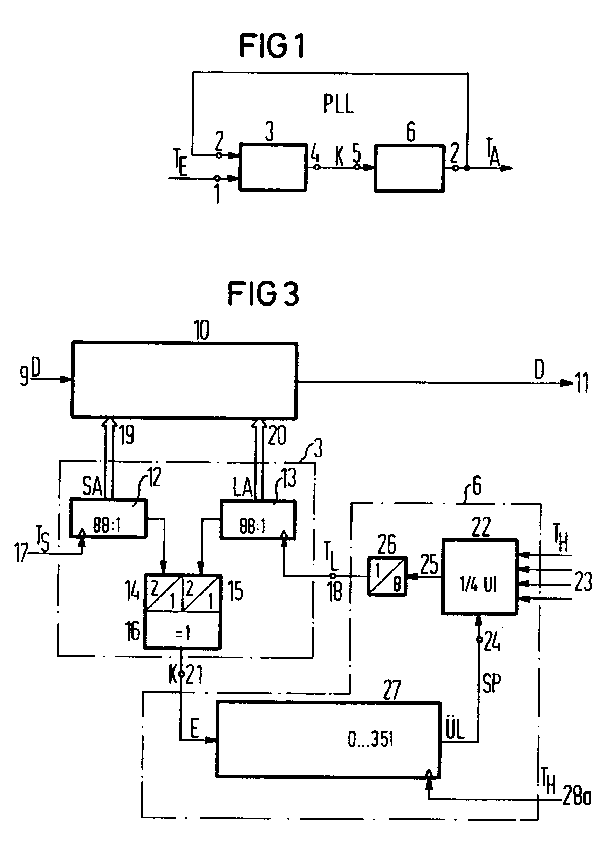

Figur 1 zeigt das Blockschaltbild einer bekannten Taktrückgewinnungseinrichtung in Form einer Phasenregelschleife PLL (Phase-locked Loop). Sie enthält einen Phasendiskriminator 3 und einen Oszillator 6.

An den Eingang 1 des Phasendiskriminators 3 wird der Eingangstakt T_{E} und an seinen Eingang 2 der Ausgangstakt T_{A} angelegt. Der Phasendiskriminator 3 gibt dann in Abhängigkeit von der Phasendifferenz zwischen dem Eingangstakt T_{E} und dem Ausgangstakt T_{A} an seinem Ausgang 4 eine Korrekturgröße K ab. Der Oszillator 6 wird von dieser derart beeinflußt, daß der von ihm erzeugte Ausgangstakt T_{A} dem Eingangstakt T_{E} in der Frequenz folgt.

Die Dimension der Korrekturgröße K hängt von der Realisierung der Schaltung ab. Bei analogen Phasenregelschleifen hat sie beispielsweise die Dimension einer Spannung und der Oszillator 6 ist ein spannungsgesteuerter.

Die Korrekturgröße K wird dem Oszillator 6 bei vielen Anwendungen über ein Filter zugeführt. Dies ist jedoch für die Erfindung unerheblich.

Einem Phasensprung des Eingangstaktes T_{E} folgt die Phase des Ausgangstaktes T_{A} mit einer Verzögerung, deren Größe von der Dimensionierung der Phasenregelschleife abhängt. Schnell ablaufende Phasenänderungen des Eingangstaktes T_{E} werden zum Ausgang hin Verlangsamt und ausgeglichen. Aus diesen Gründen enthalten Taktrückgewinnungseinrichtungen hoher Güte derartige Phasenregel-Schleifen. Der Größe der genannten Verzögerung und damit dem Grad des Ausgleichs, also der Güte der Phasenregelschleife, sind bei der Realisierung Grenzen gesetzt. Diese erlauben es nicht, die Güte der Phasenregelschleifen so hoch zu treiben, daß die durch Bytestopfen bedingten Phasensprünge des Eingangstaktes T_{E} zum Ausgang hin ausreichend verlangsamt, d.h. in Wander umgesetzt werden.

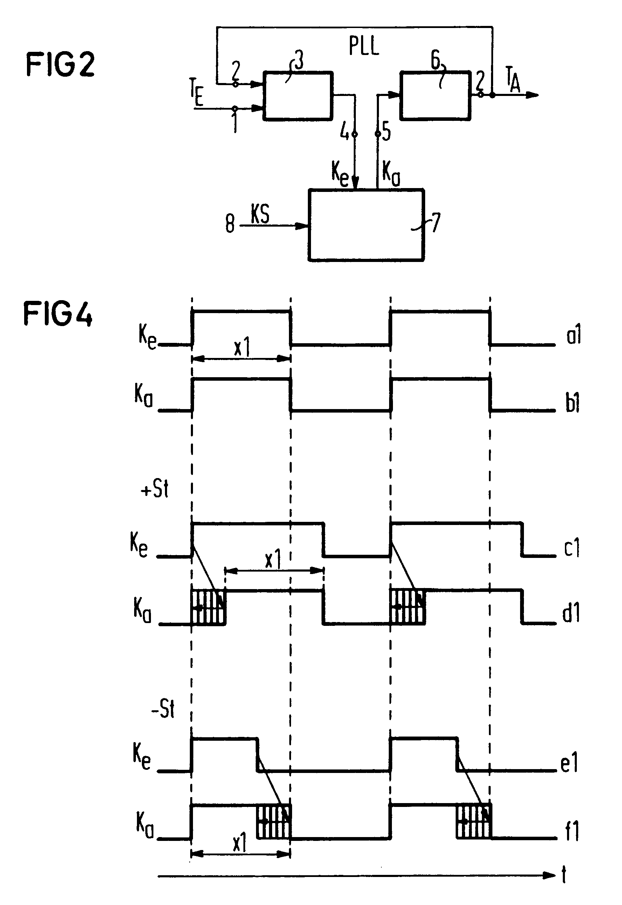

Figur 2 zeigt das Blockschaltbild der erfindungsgemäßen Taktrückgewinnungseinrichtung. Dieses unterscheidet sich von dem bekannten nach Figur 1 durch eine Einfügung eines Phasensprung-Kompensators 7, dessen Eingang mit dem Ausgang 4 des Phasendiskriminators 3 und dessen Ausgang mit dem Eingang 5 des Oszillators 6 verbunden ist. Dieser Phasensprung-Kompensator 7 empfängt eine Korrekturgröße Kₑ und gibt eine Korrekturgröße Kₐ ab. An einen Steuereingang 8 des Phasensprung-Kompensators 7 wird ein Kompensationssteuersignal KS angelegt.

Der Phasensprung-Kompensator 7 wirkt im Prinzip derart, daß er einen durch Stopfen verursachten Phasensprung des Eingangstaktes T_{E} und die dadurch erzeugte sprunghafte Veränderung der Korrekturgröße Kₑ zum Ausgang 5 hin derart ausgleicht, daß die Korrekturgröße Kₐ vom Phasensprung nicht verändert wird. Dies gilt für die Zeit während und unmittelbar nach dem Phasensprung. Mit Fortschreiten der Zeit wird die ausgleichende Wirkung des Phasensprung-Kompensators 7 kontinuierlich oder in kleinen Schritten reduziert, bis diese nach einer Ausgleichszeit, die von der Ausbildung des Phasensprung-Kompensators 7 abhängt, nicht mehr vorhanden ist. Da die Frequenz des Oszillators 6 und damit die Phase des Ausgangstaktes T_{A} von der Korrekturgröße Kₐ bestimmt werden, verteilt sich die Phasenanpassung des Ausgangstaktes T_{A} nach einem durch Stopfen hervorgerufenen Phasensprung des Eingangstaktes T_{E} über die durch den Phasensprung-Kompensator 7 vorgegebene Ausgleichszeit. Eine Dimensionierung auf sehr lange Ausgleichszeiten, beispielsweise von einigen Sekunden, ist problemlos möglich. Das erfindungsgemäße Verfahren bietet daher eine einfache Möglichkeit zur Umwandlung von Stopfjitter in Wander.

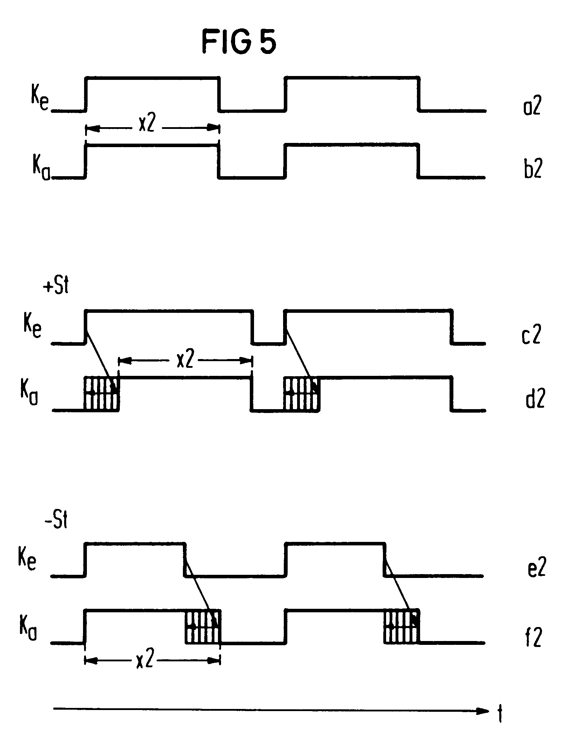

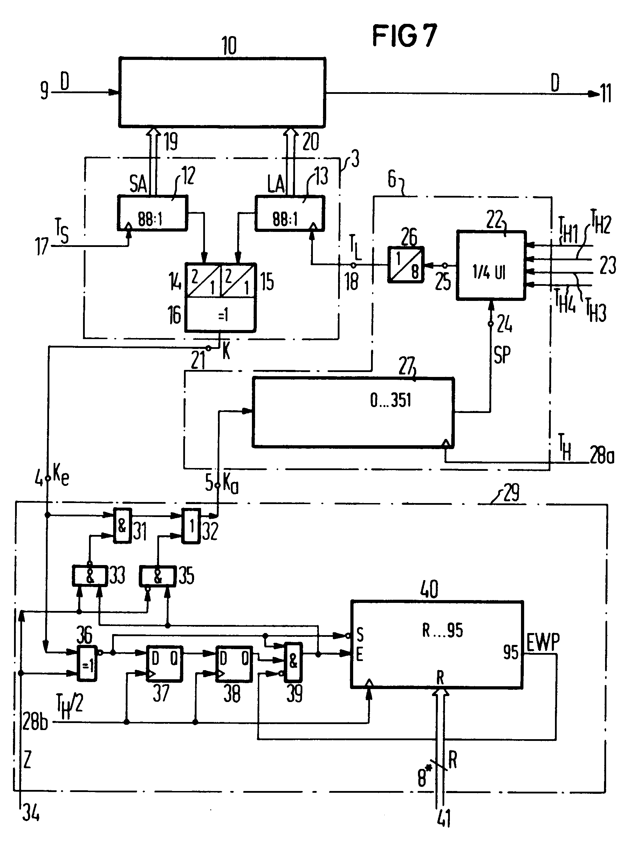

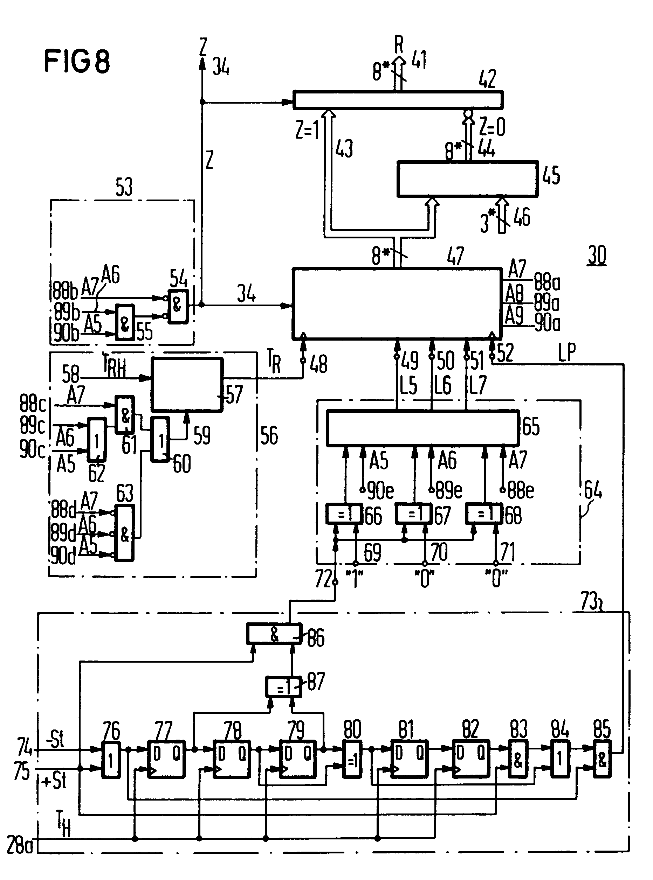

Bei dem in den Figuren 7 und 8 gezeigten Ausführungsbeispiel der Erfindung wird der Phasendiskriminator 3 und der digitale Oszillator 6 nach dem erwähnten älteren Vorschlag verwendet. Dieser ist in Figur 3 gezeigt. Der Phasendiskriminator 3 enthält dort einen Schreibzähler 12 (88:1), einen Lesezähler 13 (88:1), 2:1-Teiler 14 und 15 und ein Exklusiv-ODER-Gatter 16. Der Oszillator 6 besteht aus einem Phasenumschalter 22, einem 8:1-Teiler 26 und einem PLL-Zähler 27.

Daten D, die am Eingang 9 mit einem sehr unregelmäßigen Phasenverlauf eintreffen, werden am Ausgang 11 mit einem geglätteten Phasenverlauf weitergegeben. Dazu werden die ankommenden Daten D in einen Pufferspeicher 10 eingeschrieben. Der zugehörige sehr unregelmäßige Datentakt oder Eingangstakt T_{E} schaltet mit jeder Taktperiode den Schreibzähler 12 um Eins weiter. Der Eingangstakt T_{E} wird daher nachfolgend mit Schreibtakt T_{S} bezeichnet. Er liegt am Schreibtakteingang 17 an. Der Schreibzähler 12 bestimmt über einen Bus 19 die Schreibadresse SA des Pufferspeichers 10, in den ein Datum eingeschrieben wird. Der Ausgangstakt T_{E} der abgehenden Daten D, der jetzt mit Lesetakt T_{L} bezeichnet wird, schaltet den Lesezähler 13 weiter. Dieser bestimmt über einen Bus 20, aus welcher Leseadresse LA des Pufferspeichers 10 ein Datum ausgelesen wird. Die Kapazität des Schreibzählers 12 und die des Lesezählers 13 entspricht der Anzahl der im Pufferspeicher 10 verfügbaren Speicherplätze. Der Schreibzähler 12 und der Lesezähler 13 starten nach jedem Durchlauf wieder mit ihrem Anfangswert Null. Die Differenz ihrer Zählerstände spiegelt den Füllstand des Pufferspeichers 10 wieder. Je größer diese Differenz ist, um so voller ist der Pufferspeicher 10. Sie wird über die 2:1-Teiler 14 und 15 und das Exklusiv-ODER-Gatter 16 in eine Pulse-Pausen-Folge umgewandelt, deren Pausenanteil proportional mit der Zählerdifferenz ansteigt. Diese Pulse-Pausen-Folge entspricht der Korrekturgröße K in Figur 1.

Der PLL-Zähler 27 empfängt am Hilfstakteingang 28a einen Hilfstakt T_{H}, der den Zähler 27 mit seinen steigenden oder fallenden Taktflanken jeweils um Eins weiterschaltet. Während der Pause der Pulse-Pausen-Folge wird das Weiterschalten des Zählers 27 gestoppt. Er startet nach einem Durchlauf wieder mit seinem Anfangswert Null. Da er während einer Pause der vorgenannten Pulse-Pausen-Folge gestoppt wird, dauert sein Durchlauf um so länger, je mehr der Pufferspeicher 10 gefüllt ist. Er dauert um so kürzer, d.h. die Häufigkeit der Durchläufe ist um so höher, je weniger dieser gefüllt ist.

Dem Phasenumschalter 22 werden über seine Eingänge 23 vier jeweils um 90° versetzte Phasen T_{H1} bis T_{H4} des Hilfstaktes T_{H} zugeführt, dessen Frequenz geringfügig höher als der achtfache Nominalwert des Lesetaktes T_{L} ist. Eine dieser Phasen wird zum Ausgang 25 des Phasenumschalters 22 durchgeschaltet. Ein am Schalteingang 24 eintreffender Schaltpuls SP bewirkt eine Umschaltung auf die benachbarte Phase des Hilfstaktes T_{H} derart, daß am Ausgang 25 eine Taktperiode des abgehenden Hilfstaktes T_{H} um 90° (1/4 UI) zeitlich verlängert erscheint. Aufeinanderfolgende Schaltpulse SP bewirken daher im Mittel eine Verlangsamung des von dem Phasenumschalter 22 abgegebenen Hilfstaktes T_{H}. Dieser ergibt nach Teilung im 8:1-Teiler 26 den Lesetakt T_{L}.

Die Schaltpulse SP werden vom PLL-Zähler 27 jeweils einmal pro Durchlauf, beispielsweise am Ende des Durchlaufs während des Rücksetzens abgegeben. Je kürzer die Durchlaufzeiten des PLL-Zählers 27 sind, um so häufiger sind auch die Schaltpulse SP und um so langsamer wird die mittlere Frequenz des Lesetaktes T_{L}. Die Häufigkeit der Schaltpulse SP bzw. die Häufigkeit der Durchläufe des PLL-Zählers 27 ist, wie bereits erklärt, um so höher, je geringer die Füllung des Pufferspeichers 10 ist. Dies bewirkt andererseits eine Verlangsamung des Lesetaktes T_{L} über den Phasenumschalter 22 . Da der Schreibtakt T_{S} hiervon unberührt bleibt, beginnt sich der Pufferspeicher 10 solange zu füllen, bis sich ein Gleichgewichtszustand zwischen der Füllung des Pufferspeichers 10 und der Frequenz des Lesetaktes T_{L} einstellt.

Figur 4 zeigt die prinzipielle Wirkungsweise der Erfindung. Die symmetrische Pulse-Pausen-Folge a1 ist die Korrekturgröße Kₑ am Ausgang 4 des Phasendiskriminators 3. Dem betrachteten Zeitabschnitt ging eine längere Zeit ohne Stopfvorgänge voran. Dann läßt der Phasensprung-Kompensator 7 die Korrekturgröße Kₑ unverändert zum Ausgang 5 durch. Die Pulse-Pausen-Folgen a1 und b1 sind daher gleich. In diesem Zustand hat der Phasensprung-Kompensator 7 keine Wirkung; es erfolgt keine Modulation.

Nach positivem Stopfen +St verändert sich die Pulse-Pausen-Folge a1 der Korrekturgröße Kₑ in die Form der Pulse-Pausen-Folge c1. Die Phase des Schreibtakts hat sich stopfbedingt verzögert, wodurch sich auch die fallenden Flanken der Pulse-Pausen-Folge c1 der Korrekturgröße Kₑ verzögern. Die Pulse werden breiter und die Pausen entsprechend kürzer. Der Phasensprung-Kompensator 7 verzögert nun die steigenden Flanken der Pulse-Pausen-Folge d1 der Korrekturgröße Kₐ um genau den Betrag, um den die fallende Flanke stopfbedingt verzögert wurde. Damit bleiben die Pulsdauer x1 der Pulse-Pause-Folge d1 der Korrekturgröße Kₐ vorerst unverändert und damit auch die Oszillatorfrequenz und die Phase des Lesetaktes T_{L}. Anschließend wird die Verzögerung der steigenden Flanke der Pulse-Pausen-Folge d1 der Korrekturgröße Kₐ in kleinen Schritten zurückgenommen, wodurch sich die Phase des Lesetaktes T_{L} langsam verschiebt. Nach Ablauf der Ausgleichszeit stimmen die Flanken der Pulse-Pausen-Folgen c1 und d1 wieder überein; der Phasensprung-Kompensator 7 schaltet die Korrekturgröße Kₑ zum Ausgang durch.

Nach negativem Stopfen -St erfolgen die Abläufe entsprechend, wie die Pulse-Pausen-Folgen e1 und f1 zeigen. Die Phase des Schreibtakts ist stopfbedingt vorgeeilt, wodurch die fallenden Flanken der Korrekturgröße Kₑ zeitlich nach vorne geschoben werden. Der Phasensprung-Kompensator 7 verzögert die fallende Flanke der Korrekturgröße Kₐ genau um den gleichen Betrag, wodurch deren Puls- und Pausendauer vorerst unverändert bleiben. Der weitere Ablauf erfolgt wie beim positiven Stopfen +St.

Der Phasensprung-Kompensator 7 wandelt Phasensprünge also in eine langsam rampenförmig ansteigende Phasenänderung um.

Die Figur 5 zeigt die anhand der Figur 4 beschriebenen Vorgänge mit Pulse-Pausen-Folge a2 bis f2 für eine asymmetrische Pulse-Pausen-Folge a2 mit einer Pulsdauer x2.

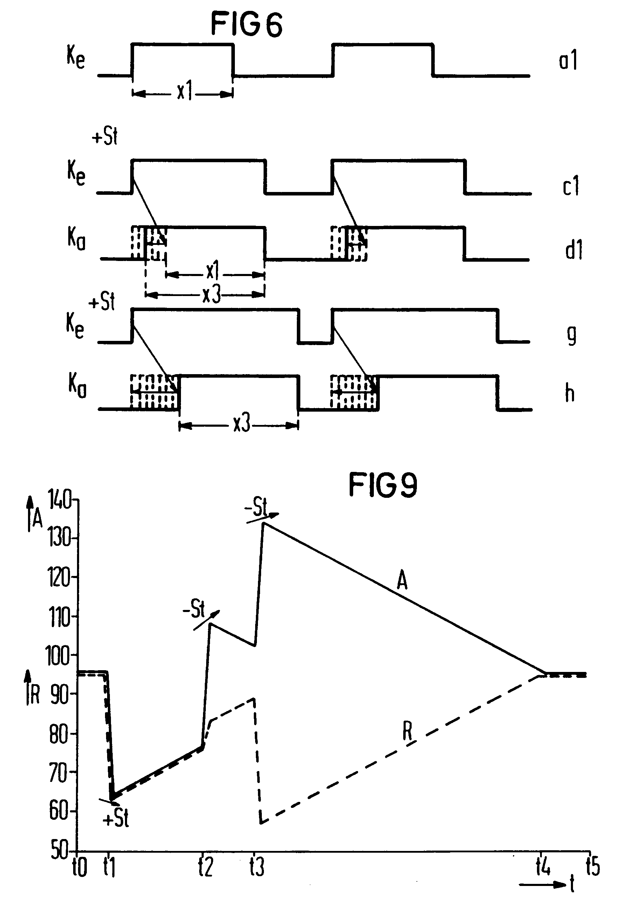

Die Figur 6 zeigt die Pulse-Pausen-Folgen a1, c1 und d1 nach Figur 4. Während jedoch in der Pulse-Pausen-Folge d1 der Ausgleich noch nicht abgeschlossen ist und die Pulsdauer gerade x3 beträgt, erfolgt ein neues positives Stopfen und die Korrekturgröße Kₑ nimmt die Pulse-Pausen-Folge g an. Jetzt muß für die Korrekturgröße Kₐ in der Pulse-Pausen-Folge h ein längerer Ausgleich erfolgen.

Die Figuren 7 und 8 zeigen zusammen die erfindungsgemäße Taktrückgewinnungseinrichtung. Die Figur 7 enthält oben die bereits in Figur 3 gezeigte Taktrückgewinnungseinrichtung und unten einen Rampengenerator 29 als Teil des Phasensprung-Kompensator 7. Figur 8 zeigt mit einer Rampengenerator-Steuereinrichtung 30 einen in Figur 7 noch fehlenden Teil des Phasensprung-Kompensator 7. Die Figur 9 zeigt ein Diagramm zur Erläuterung des Verfahrensablaufs.

Der Rampengenerator 29 in Figur 7 enthält UND-Gatter 31, 35 und 39, ein ODER-Gatter 32, ein NAND-Gatter 33, ein Exklusiv-ODER-Gatter 36, D-Flipflops 37 und 38 sowie einen Rampenzähler 40. Im Rampengenerator 29 erfolgt die vorstehend beschriebene Verzögerung der Flanken. Die Bezeichnung "Rampengenerator" beruht auf der durch ihn erzeugten rampenförmig ansteigenden Phasenänderung. Die im folgenden genannten Zahlen sind weitgehend veränderbar.

Die Pulse-Pausen-Folge der Korrekturgröße Kₑ am Eingang 4 wird über das UND-Gatter 31 und das ODER-Gatter 32 zum Ausgang 5 geführt, soweit diese durchlässig sind. Der Rampenzähler 40 wird durch einen Hilfstakt halber Frequenz T_{H}/2 am Hilfstakteingang 28b weitergeschaltet. Erreicht sein Zählerstand den Endwert EW=95, wird er in diesem Zustand mittels eines Endwertpulses EWP über das UND-Gatter 39 und den Vorbereitungseingang E solange verriegelt, bis der Zählerstand durch einen Puls am Setzeingang S auf seinen Startwert gesetzt wird. Nachfolgend zählt er wieder hoch und der geschilderte Ablauf wiederholt sich. Den Startwert erhält der Rampengenerator 29 von der Rampengenerator-Steuereinrichtung 30 in Figur 8 über einen Bus 41 mit acht Leitungen 8*.

Nach einer längeren Zeit ohne Stopfen gibt die Rampengenerator-Steuereinrichtung 30 einen Startwert R=95 ab. In diesem Zustand sind Startwert R und Endwert EW des Rampenzählers 40 gleich. Er verbleibt somit auf dem Zählerstand R=95 auch dann, wenn er über den Bus 41 auf den Startwert gesetzt wird. Während des Zählerstand-Endwerts EW=95 liegt der Vorbereitungseingang E auf Null. Damit sind das NAND-Gatter 33 und das UND-Gatter 35 gesperrt, die ihrerseits das UND-Gatter 31 und das ODER-Gatter 32 so ansteuern, daß die Korrekturgröße Kₑ zum Ausgang 5 hin nicht verändert wird, wie es Figur 4, Folgen a1 und b1 zeigt.

Tritt nun ein positives Stopfen +St auf, dann verringert die Rampengenerator-Steuereinrichtung 30 den Startwert auf R=95-32=63 und setzt den Zustand des Zählrichtungssignals Z am Zählrichtungs-Steueranschluß 34 auf logisch "1". Der Rampenzähler 40 bleibt jedoch vorerst verriegelt, da der Vorbereitungseingang E einen Zustand logisch "0" hat. Der Zustand logisch "1" des Zählrichtungssignals Z bewirkt, das am Ausgang des Exklusiv-NOR-Gatters 36 die Pulse-Pausen-Folge der Korrekturgröße Kₑ unverändert anliegt.

Während eines Zustands logisch "1" einer Pulse-Pausen-Folge einer Korrekturgröße Kₑ bleibt der Zustand des Rampenzählers 40 vorerst unverändert. Während der nachfolgenden Pause mit dem logischem Zustand "0" wird der Rampenzähler 40 auf einen Startwert R=63 gesetzt. Der Vorbereitungseingang E bleibt jedoch auf logisch "0", da der Ausgang des Exklusiv-NOR-Gatters 36 auch den logischen Zustand "0" aufweist. Mit Beginn des nachfolgenden Pulses der Korrekturgröße Kₑ geht der Ausgang des UND-Gatters 39 auf logisch "1", wodurch der Rampenzähler 40 freigegeben wird. Die Einschaltung der beiden D-Flipflops 37 und 38 ist technologisch bedingt und verhindert metastabile Zustände. Der Zustand logisch "1" am Ausgang des UND-Gatters 39 sperrt über das NAND-Gatter 33 das UND-Gatter 31, wodurch sich ein Zustand der Korrekturgröße Kₐ logisch "0" ergibt. Der Rampenzähler 40 erhöht mit jeder Periode des Hilfstaktes T_{H} seinen Zählerstand um Eins. Nach zweiunddreißig Perioden erreicht er den Wert 95. Wechselt der Endwertpuls EWP auf einen Zustand logisch "1", geht der Ausgang des UND-Gatters 39 auf einen Zustand logisch "0" und bleibt der Rampenzähler 40 auf dem Stand 95 stehen. Gleichzeitig wird das UND-Gatter 31 über das NAND-Gatter 33 freigegeben, wodurch sich ein Zustand der Korrekturgröße Kₐ logisch "1" ergibt. Die Frequenz des Hilfstaktes T_{H} und Änderungen des Startwertes R nach einem Stopfen müssen so abgestimmt werden, daß die Laufzeit des Rampenzählers 40 genau der zeitlichen Verzögerung der fallenden Flanke der Pulse-Pausen-Folge c1 in Figur 4 entspricht. Während der nachfolgenden Pause der Korrekturgröße Kₑ wird der Rampenzähler 40 wieder auf den Startwert R gesetzt, und der Ablauf wiederholt sich. Die Rampengenerator-Steuereinrichtung 30 erhöht nun in regelmäßigen Abständen den Startwert R solange jeweils um Eins, bis wieder der Wert R=95 erreicht wird; es sei denn, daß der Startwert R vorher durch einen neuen Stopfvorgang entsprechend verändert wurde. Diesen Ablauf zeigen die Folgen c1 und d1 in Figur 4.

Der Vorgang nach einem negativen Stopfen -St verläuft entsprechend. Die Rampengenerator-Steuereinrichtung 30 setzt den Zustand des Zählrichtungssignals Z am Zählrichtungs-Steueranschluß 34 auf logisch "0". Am Ausgang des Exklusiv-NOR-Gatters 36 liegt die Korrekturgröße Kₑ invertiert an. Im Unterschied zum positiven Stopfen +St bleibt das UND-Gatter 31 immer geöffnet. Die Pulsdauer wird von der fallenden Flanke der Korrekturgröße Kₑ, gesteuert über das UND-Gatter 35 und ODER-Gatter 32, verlängert. Siehe die Folgen e1 und f1 in Figur 4.

Die Figur 9 zeigt Anfangswerte A und Startwerte R für einen längeren Ablauf ohne Stopfen bis zum Zeitpunkt t1, für ein positives Stopfen +St zum Zeitpunkt t1, für negatives Stopfen -St zu den Zeitpunkten t2 und t3 und für einen ausgeglichenen Verlauf zwischen den Zeitpunkten t4 und t5. Zu den Zeitpunkten t1, t2 und t3 wurde jeweils ein Ausgleichsvorgang vorzeitig unterbrochen.

Figur 8 zeigt die Rampengenerator-Steuereinrichtung 30. Diese enthält einen als Datenselektor arbeitenden Multiplexer 42, einen Volladdierer 45, einen 8-bit-Anfangswert-Zähler 47, einen Zählrichtungs-Steuerschaltung 53, eine Rampentakt-Steuerschaltung 56, einen Addierer 64 und eine Addierersteuerung 73.

Die Zählrichtungs-Steuerschaltung 53 enthält UND-Gatter 54 und 55. Die Rampentakt-Steuerschaltung 56 besitzt einen 3:1/1:1-Teiler 57, ODER-Gatter 60 und 62 sowie UND-Gatter 61 und 63. Der Addierer 64 umfaßt einen Volladdierer 65 und Exklusiv-ODER-Gatter 66, 67 und 68. Die Addierersteuerung 73 enthält schließlich ODER-Gatter 76 und 84, D-Flipflops 77, 78, 79, 81 und 82, Exklusiv-ODER-Gatter 80 und 87 sowie UND-Gatter 83, 85 und 86.

Den Kern der Rampengenerator-Steuereinrichtung 30 bildet der Anfangswert-Zähler 47. Dieser ist ein handelsüblicher Zähler, dessen Aufwärts- oder Abwärtszählrichtung vom logischen Zustand "1" oder "0" des Zählrichtungs-Steueranschlusses 34 abhängt. Im gewählten Beispiel wird bei dem Zustand logisch "1" aufwärts gezählt. Der den Anfangswert-Zähler 47 treibende Takt ist der am Rampentakteingang 48 anliegende Rampentakt T_{R}, dessen Frequenz die Zählgeschwindigkeit bestimmt. Am ausgangsseitigen Bus 43 des Anfangswert-Zählers 47 liegt dessen Zählerstand A als binäre Zahl an.

Dem mittleren dezimalen Anfangswert A=96 entspricht die binäre Zahl "01100000", deren Stellen mit A7 bis A0 bezeichnet werden. Es ist also A7=0, A6=1 und A5=1.

Legt man diese Werte für A5, A6 und A7 an die UND-Gatter 54 und 55 an, dann tritt am Ausgang 34 des UND-Gatters 54 ein logischer Zustand "0" auf, was ein Abwärtszählen des Anfangswerts-Zählers 47 bewirkt. Für Dezimalwerte A<96 ist A7=0, und sind A6 und A5 nicht beide auf Eins. Bei dieser Konstellation tritt am Ausgang 34 des UND-Gatters 54 ein Zustand logisch "1" auf, was ein Aufwärtszählen des Anfangswert-Zählers 47 auslöst. Dies hat zur Folge, daß der Zählerstand des Anfangswert-Zählers 47 periodisch mit dem Rampentakt T_{R} zwischen den Dezimalwerten A=96 und A=95 wechselt, solange kein Ladepuls LP am Ladepulseingang 52 auftritt.

Nach dem Auftreten eines Ladepulses LP wechselt der Zählerstand des Anfangswert-Zählers 47 auf das an den Ladeeingängen 49 bis 51 anliegende Codewort L5, L6 und L7. Es übernimmt somit A7 den Wert L7, A6 den von L6 und A5 den von L5. Die Werte von A4 bis A0 werden nicht verändert.

Die Erzeugung des Ladepulses LP sowie die richtige Einstellung des Zustands des Steuereingangs 72 der Addierschaltung 64 erfolgt in der Addiersteuerung 73. Wird bei dieser entweder an den Eingang 74 eine logische "1" für negatives Stopfen -St oder an den Eingang 75 eine logische "1" für positives Stopfen +St angelegt, dann nimmt der Ausgang des ODER-Gatters 76 ebenfalls den Zustand logisch "1" an. Dieser Zustand wird mit dem Hilfstakt T_{H} am Hilfstakteingang 28a schrittweise über die D-Flipflops 77, 78 und 79 übertragen. Liegt am Q-Ausgang des D-Flipflops 77 eine logische "1" und am Q-Ausgang des D-Flipflops 79 eine logische "0" oder umgekehrt, gibt das Exklusiv-ODER-Gatter 87 eine logische "1" an das UND-Gatter 86 ab. Liegt weiter am Eingang 75 eine logische "1", dann tritt am Steuereingang 72 ebenfalls eine logische "1" auf.

Wenn am Q-Ausgang des D-Flipflops 78 und am Q-Ausgang des D-Flipflops 79 unterschiedliche logische Zustände anliegen, gibt das Exklusiv-ODER-Gatter 80 eine logische "1" ab. Diese wird mit dem Hilfstakt T_{H} schrittweise über die D-Flipflops 81 und 82 zum ersten Eingang des UND-Gatters 83 übertragen. Liegt gleichzeitig am Eingang 75 ein logischer Zustand "1" an, dann tritt auch am Ausgang des UND-Gatter 83 eine logische "1" auf. Ist dies der Fall, oder ist der Ausgang des Exklusiv-ODER-Gatters 80 im Zustand logisch "1", dann gibt das ODER-Gatter 84 diesen Zustand an den ersten Eingang des UND-Gatters 85 weiter. Ist jetzt gleichzeitig der Ausgang des ODER-Gatters 76 im Zustand logisch "1", dann gibt das UND-Gatter 85 einen Ladepuls LP an den Ladepulseingang 52 des Anfangswert-Zählers 47 ab.

Im Addierer 64 ist der Addierereingang 69 in den Zustand logisch "1", der Addierereingang 70 in den Zustand logisch "0" und der Addierereingang 71 in den Zustand logisch "0" gesetzt.

Im Fall eines negativen Bytestopfens - was einer Beschleunigung der ankommenden Daten D um acht UI entspricht - muß der dezimale Anfangswert A um zweiunddreißig erhöht werden.

Wenn der Steuereingang 72 bei negativem Bytestopfen -St am Steuereingang 72 eine logisch "0" empfängt, dann tritt am Ausgang des Exklusiv-ODER-Gatters 66 eine logische "1", am Ausgang des Exklusiv-ODER-Gatters 67 eine logische "0" und am Ausgang des Exklusiv-ODER-Gatters 68 eine logische "0" auf. Das durch die drei Exklusiv-ODER-Gatter 66 bis 68 gebildete Codewort lautet dann, beginnend mit der höchstwertigsten Stelle, "001". Wird hierzu beispielsweise für A7, A6 und A5 das Codewort "011" eingesetzt, dann ergibt sich für L7, L6 und L5 an den Ladeeingängen 51, 50 und 49 des Anfangswert-Zählers 47 ein Codewort "100" für die Dezimalzahl 128. Mit dem nun nachfolgenden Ladepuls LP wird der Zählerstand um dezimal zweiunddreißig erhöht.

Im Fall eines positiven Bytestopfens +St muß der Zählerstand des Anfangswert-Zählers 47 um einen Dezimalwert zweiunddreißig verringert werden. Erscheint für positives Bytestopfen +St am Steuereingang 72 eine logische "1", dann erhält der Ausgang des Exklusiv-ODER-Gatters 66 eine logische "0", der Ausgang des Exklusiv-ODER-Gatters 67 eine logische "1" und der Ausgang des Exklusiv-ODER-Gatters 68 eine logische "1". Beginnend mit der höchstwertigsten Stelle liegt demnach an den Exklusiv-ODER-Gattern 66, 67 und 68 ein Codewort "110" an. Addiert mit dem oben als Beispiel gewählten Codewort "011" für A7, A6 und A5 ergibt die Summe L7, L6 und L5 ohne Übertrag ein Codewort "001". Mit einem Ladepuls LP am Ladepulseingang 52 wird dieses Codewort, das die Dezimalzahl zweiunddreißig beinhaltet als Anfangswert A=32 vom Anfangswert-Zähler 47 übernommen. In der nächsten Periode des Hilfstaktes T_{H} am Hilfstakteingang 28a erhält der Steuereingang 72 den logischen Zustand "0". Das Exklusiv-ODER-Gatter 66 nimmt jetzt den logischen Zustand "1", das Exklusiv-ODER-Gatter 67 den logischen Zustand "0" und das Exklusiv-ODER-Gatter 68 den logischen "0" an. Der Volladdierer 65 addiert jetzt die Codewörter "001" und "001". Das Ergebnis L7, L6 und L5 ist ein Codewort "010". Dieses entspricht dem Dezimalwert 64 und wird mit dem nächsten Ladepuls LP am Ladepulseingang 52 als endgültiger Anfangswert A vom Anfangswert-Zähler 47 aufgenommen.

In der Rampentakt-Steuerschaltung 56 wird der Rahmenhilfstakt T_{RH} - wenn am Schalteingang 59 eine logische "1" anliegt - durch den 3:1/1:1-Teiler 57 ungeteilt als Rahmentakt T_{R} zum Ausgang 41 durchgelassen. Hat der Schalteingang 59 dagegen den logischen Zustand "0" dann wird der Rahmenhilfstakt T_{RH} 3:1 geteilt, bevor er als Rahmentakt T_{R} zum Ausgang 48 gelangt. Der Ausgang des UND-Gatters 61 erhält dann einen Zustand "1", wenn das Codewort A7, A6 und A5 entweder "101", "110" oder "111" beträgt. Der Ausgang des UND-Gatters 63 nimmt den Zustand logisch "1" an, wenn das Codewort A7, A6 und A5 "000" ist. Das ODER-Gatter 60 liefert dem Schalteingang 59 dann eine logische "1", wenn entweder am Ausgang des UND-Gatters 61 oder am Ausgang des UND-Gatters 63 eine logische "1" anliegt. Am Schalteingang 59 kann nur dann eine logische "0" auftreten, wenn A7, A6 und A5 Codewörter "001", "010" oder "011" bilden. Die Dezimalwerte liegen dann zwischen zweiunddreißig und hundertneunundfünfzig.

Der vom Anfangswert-Zähler 47 abgegebene Anfangswert A muß zum Startwert R des Rampenzählers 29 umgeformt werden. Wenn A<96 ist, wird der vorläufige Startwert einfach über den Bus 43, den Multiplexer 42 und den Bus 41 als endgültige Startwert R weitergegeben. Ist A>95 wird der vorläufige Startwert nach der Formel R= 191-A im Addierer 45 umgerechnet, indem ihm über den Bus 46 die Binärzahl "010", die der Dezimalzahl 64 in den Stellen A7, A6 und A5 entspricht, zugeführt und das Ergebnis invertiert wird. Dieses wird über den Multiplexer 42 und den Bus 41 weitergeleitet.

Wenn längere Zeit keine Stopfvorgänge aufgetreten sind, wechselt A, wie bereits beschrieben, zwischen den Dezimalzahlen 95 und 96. In beiden Fällen ist jedoch R=95; dem Rampenzähler 40 wird somit konstant R=95 zugeführt.

## Patentansprüche

1. Verfahren zur Taktrückgewinnung für empfangene und zwischengespeicherte Daten (D), die durch Stopfvorgänge an die übertragungsgeschwindigkeit angepaßt wurden und bei dem die Phase eines unregelmäßigen Schreibtaktes (T_{S}) mit der Phase eines in einen Phasenregelkreis gewonnenen kontinuierlichen Lesetaktes (T_{L}) verglichen wird und die Frequenz des Lesetaktes (T_{L}) in Abhängigkeit vom Vergleichsergebnis mit Hilfe einer Korrekturgröße (Kₑ) gesteuert wird, die einem steuerbaren Oszillator (6) zugeführt wird,
**dadurch gekennnzeichnet**,
daß aus der Stopfinformation der empfangenen Daten (D) ein Kompensationssteuersignal (KS) für einen erfolgenden Stopfvorgang (+St,-St) ermittelt wird, der eine sprunghafte Änderung der Korrekturgröße (Kₑ) verursacht,
daß das Kompensationssteuersignal (KS) einem Phasensprung-Kompensator (7) zugeführt wird, der aus dem ihm zugeführten Korrektursignal (Kₑ) eine Ausgangskorrekturgröße (Kₐ) ermittelt, die den Oszillator (6) steuert, und der zunächst sprunghafte Änderungen der Ausgangskorrekturgröße (Kₐ) unterdrückt und die Ausgangskorrekturgröße (Kₐ) kontinuierlich oder in kleinen Schritten an die Korrekturgröße (Kₑ) anpaßt.

2. Verfahren nach Anspruch 1,
**dadurch gekennzeichnet**,
daß durch den Phasensprung-Kompensator (7) ein Kompensationssignal (E̅W̅P̅) erzeugt wird, das mit der Korrekturgröße (Kₑ) zu der Ausgangskorrekturgröße (Kₐ) zusammengefaßt wird.

3. Verfahren nach Anspruch 1,
**dadurch gekennzeichnet**,
daß die Änderungsgeschwindigkeit der Ausgangskorrekturgröße (Kₐ) von der durch Stopfvorgänge (+St, -St) verursachten Korrekturgröße (Kₑ) bestimmt wird.

4. Verfahren nach Anspruch 1, 2 oder 3,
**dadurch gekennzeichnet**,
daß als Korrekturgröße (Kₑ) eine binäre Pulse-Pausen-Folge (a1, c1, e1) erzeugt wird,
daß bei einer Verlängerung eines Binärzustands (log. 1) des Korrektursignals (Kₑ) durch einen Stopfvorgang (+St) die Vorderflanke dieses Binärzustands (log. 1) durch das Kompensationssignal (E̅W̅P̅) zunächst verzögert wird und daß bei einer Verkürzung des einen Binärzustands (log. 1) des Korrektursignals (Kₑ) durch einen Stopfvorgang (-St) die Hinterflanke dieses Binärzustands (log. 1) durch das Kompensationssignal (E̅W̅P̅) zunächst verzögert wird, so daß in beiden Fällen das Puls-Pause-Verhältnis zunächst zumindest annähernd gleich bleibt und dann in beiden Fällen die Verzögerungsdauer der Flanken verringert wird.

5. Taktrückgewinnungseinrichtung für Daten (D),
die mit einem unregelmäßigen Schreibtakt (T_{S}) in einen Pufferspeicher (10) eingeschrieben wird und mit einem in einer einen steuerbaren Oszillator (6) und einen Phasendiskriminator (3) enthaltenden Phasenregelschleife (PLL) erzeugten kontinuierlichen Lesetakt (L_{S}) ausgelesen wird,
**dadurch gekennzeichnet**,
daß ein digitaler Oszillator (6) vorgesehen ist, dessen Frequenz über die Zählperiodendauer eines PLL-Zählers (27) gesteuert wird,
daß ein Phasendiskriminator (3) mit einem Schreibzähler (12) und einem Lesezähler (13) vorgesehen ist, aus deren Ausgangssignalen als Korrekturgröße (Kₑ) eine binäre Pulse-Pausen-Folge (a1, c1, e1) gewonnen wird,
daß ein Rampengenerator (29) mit einem einstellbaren Rampenzähler (40) vorgesehen ist,
daß eine Rampengenerator-Steuereinrichtung (30) vorgesehen ist, die bei jedem Stopfvorgang (+St, -St) den Rampenzähler (40) einstellt, der ein seiner Zähldauer entsprechendes Kompensationssignal (E̅W̅P̅) abgibt,
daß über ein Gatternetzwerk (31, 32, 33, 35) mit der Korrekturgröße (Kₑ) des Phasendiskriminators (3) verknüpft wird und ein dem Oszillator (6) zugeführtes Ausgangskorrektursignal (Kₐ) abgibt, und dann durch Verringerung der Zähldauer des Rampenzählers (40) das Kompensationssignal (E̅W̅P̅) schrittweise verkleinert, und nach Beendigung des Zählvorganges einen Endwertpuls (EWP) abgibt, der das Korrektursignal (Kₑ) als Ausgangskorrektursignal (Kₐ) an den Oszillator (6) durchschaltet.

6. Taktrückgewinnungseinrichtung nach Anspruch 5,
**dadurch gekennzeichnet**,
daß in der Rampengeneratorsteuereinrichtung (20) ein einstellbarer Anfangswertzähler (47) vorgesehen ist, dessen Einstelleingängen (49, 50, 51) ein Volladoierer (65) vorgeschaltet ist und dessen Zählerstand bei jedem Stopfvorgang (+St, -St) um einen konstanten Betrag vergrößert oder verkleinert wird und dessen Zählerstand den Einstellwert (R) des Rampenzählers (40) bestimmt und diesen Einstellwert (R) zwischen den Stopfvorgängen (+St, -St) schrittweise verändert.

7. Taktrückgewinnungseinrichtung nach Anspruch 5 oder 6,
**dadurch gekennzeichnet**,
daß dem Takteingang des Anfangswertzählers (47) ein umschaltbarer Teiler (57) vorgeschaltet ist, dessen Teilungsverhältnis in Abhängigkeit des Zählerstandes (A7, A6, A5) des Anfangswertzählers (47) umschaltbar ist und hierdurch unterschiedlich schnelle Änderungen des Kompensationssignals (E̅W̅P̅) bewirkt.

8. Taktrückgewinnungseinrichtung nach einem der Ansprüche 5 bis 7,
**dadurch gekennzeichnet**,
daß als Rampengenerator (29) vorgesehen ist
ein erstes UND-Gatter (31), dessen erster Eingang mit dem Eingang (4) des Phasensprung-Kompensators (7) verbunden ist, ein erstes ODER-Gatter (32), dessen erster Eingang mit dem Ausgang des ersten UND-Gatters (31) und dessen Ausgang mit dem Ausgang (5) des Phasensprung-Kompensators (7) verbunden ist,
ein erstes NAND-Gatter (33), dessen erster Eingang mit einem Zählrichtungs-Steueranschluß (34) und dessen Ausgang mit dem zweiten Eingang des ersten UND-Gatters (31) verbunden ist,
ein zweites UND-Gatter (35), dessen erster invertierender Eingang mit dem Zählrichtungs-Steueranschluß (34) und dessen Ausgang mit dem zweiten Eingang des ersten ODER-Gatters (32) verbunden ist,
ein Exklusiv-NOR-Gatter (36), dessen erster Eingang mit dem Eingang (4) des Phasensprung-Kompensators (7) und dessen zweiter Eingang mit dem Zählrichtungs-Steueranschluß (34) verbunden ist,
ein erstes D-Flipflop (37), dessen D-Eingang mit dem Ausgang des Exklusiv-NOR-Gatters (36) und dessen Takteingang mit einem Hilfstakteingang (28b) verbunden ist,
ein zweites D-Flipflop (38), dessen D-Eingang mit dem Q-Ausgang des ersten D-Flipflops (37) und dessen Takteingang mit dem Hilfstakteingang (28b) verbunden ist,
ein drittes UND-Gatter (39), dessen erster Eingang mit dem Ausgang des Exklusiv-NOR-Gatters (36) und dessen zweiter Eingang mit dem Q-Ausgang des zweiten D-Flipflops (38) verbunden ist, und
ein Rampenzähler (40), dessen Ausgang mit einem dritten invertierenden Eingang des dritten UND-Gatters (39), dessen invertierender Setzeingang mit dem Ausgang des Exklusiv-NOR-Gatters (36), dessen Vorbereitungs-Eingang sowohl mit dem Ausgang des dritten UND-Gatters (39) als auch mit dem zweiten Eingang des NAND-Gatters (33) als auch mit dem zweiten Eingang des zweiten UND-Gatters (35), dessen Takteingang mit dem Hilfetakteingang (28b) und dessen Startwerteingang mit einem Startwertbus (41) verbunden ist.

9. Taktrückgewinnungseinrichtung nach einem der Ansprüche 5 bis 8,
**dadurch gekennzeichnet**,
daß als Rampengenerator-Steuereinrichtung (30) vorgesehen ist ein 8-bit-Anfangswert-Zähler (47), dessen Zählrichtungs-Steueranschluß (34) mit einer Zählrichtungs-Steuerschaltung (53) und dem Rampengenerator (29), dessen Rampentakteingang (48) mit einer Rampentakt-Steuerschaltung (56), dessen drei Ladeeingänge (49, 50, 51) mit Ausgängen eines Addierers (64) für die drei höchstwertigsten Bits, dessen Ladepulseingang (52) eine Addierer-Steuerung (73), dessen acht Ausgänge mit einem ersten Bus (43) und dessen drei Nebenausgänge (86a, 87a, 88a) für die drei höchstwertigsten Bits (A7, A6, A5) des Zahlerstandes mit der Zählrichtungs-Steuerschaltung (53), der Rampentakt-Steuerschaltung (56) und dem Addierer (64) verbunden ist, mit einem ersten Volladdierer (45), dessen acht erste Eingänge über einen ersten Bus (43) mit den acht Ausgängen des Anfangswert-Zählers (47) und dessen drei zweite Eingänge für die drei höchstwertigsten Bits einer Binärzahl zu 64 mit einem zweiten Bus (46) verbunden sind, und
ein Multiplexer (42), dessen erste Eingänge mit dem ersten Bus (43), dessen zweite invertierende Eingänge über einen dritten Bus (44) mit den acht Ausgängen des ersten Volladdierers (45), dessen Steuereingang mit dem Zählrichtungs-Steueranschluß (34) und dessen acht Ausgänge mit dem Startwertbus (41) verbunden sind.

10. Taktrückgewinnungseinrichtung nach Anspruch 9,
**dadurch gekennzeichnet**,
daß als Zählrichtungs-Steuerschaltung (53) vorgesehen ist ein viertes UND-Gatter (54), dessen erster invertierender Eingang mit dem ersten Nebenausgang (86b) des AnfangswertZählers (47) und dessen Ausgang mit den Zählrichtungs-Steueranschluß (34) verbunden ist, und
ein fünftes UND-Gatter (55) vorgesehen sind, dessen erster Eingang mit dem zweiten Nebenausgang (87b) des Anfangswert-Zählers (47), dessen zweiter Eingang mit dem dritten Nebenausgang (88b) des Anfangswert-Zählers (47) und dessen Ausgang mit dem zweiten invertierenden Eingang des vierten UND-Gatters (54) verbunden ist.

11. Taktrückgewinnungseinrichtung nach Anspruch 9,
**dadurch gekennzeichnet**,
daß als Rampentakt-Steuerschaltung (56) vorgesehen ist ein umschaltbarer 3:1/1:1-Teiler (57) mit einem Rampenhilfstakt-Eingang (58) und einem Umschaltsignaleingang (59), ein zweites ODER-Gatter (60), dessen Ausgang mit dem Umschaltsignaleingang (59) verbunden ist,
ein sechstes UND-Gatter (61), dessen erster Eingang mit dem ersten Nebenausgang (88c) des Anfangswert-Zählers (47) und dessen Ausgang mit dem ersten Eingang des ODER-Gatters (60) verbunden ist,
ein drittes ODER-Gatter (62), dessen erster Eingang mit dem zweiten Nebenausgang (89c) des Anfangswert-Zählers (47), dessen zweiter Eingang mit dem dritten Nebenausgang (90c) des Anfangswert-Zählers (47) und dessen Ausgang mit dem zweiten Eingang des sechsten UND-Gatters (61) verbunden ist, und
ein siebentes UND-Gatter (63), dessen erster invertierter Eingang mit dem ersten Nebenausgang (88d) des Anfangswert-Zählers (47), dessen zweiter invertierender Eingang mit dem zweiten Nebenausgang (89d) des Anfangswert-Zählers (47), dessen dritter invertierender Eingang mit dem dritten Nebenausgang (90d) des Anfangswert-Zählers (47) und dessen Ausgang mit dem zweiten Eingang des zweiten ODER-Gatter (60) verbunden ist.

12. Taktrückgewinnungseinrichtung nach Anspruch 9,
**dadurch gekennzeichnet**,
daß als Addierer (64) vorgesehen ist
ein zweiter Volladdierer (65), dessen Ausgang mit den drei Ladeeingängen (49, 50, 51) des Anfangswert-Zählers (47) und dessen erster Eingang (88e, 89e, 90e) mit den Nebenausgängen (88a, 89e, 90a) des Anfangswert-Zählers (47) verbunden sind, ein viertes Exklusiv-ODER-Gatter (68), dessen erster Eingang mit dem Steuereingang (72), dessen zweiter Eingang mit einem dritten Addiereingang (71) und dessen Ausgang mit dem ersten Nebenausgang (88e) des Anfangswert-Zählers (47) verbunden ist, ein drittes Exklusiv-ODER-Gatter (67), dessen erster Eingang mit dem Steuereingang (72), dessen zweiter Eingang mit einem zweiten Addierereingang (70) und dessen Ausgang mit dem zweiten Nebenausgang (89e) des Anfangswert-Zählers (47) verbunden ist, und
ein zweites Exklusiv-ODER-Gatter (66) vorgesehen ist, dessen erster Eingang mit dem Steuereingang (72), dessen zweiter Eingang mit einem ersten Addierereingang (69) und dessen Ausgang mit dem dritten Nebenausgang (90e) des Anfangswert-Zählers (47) des zweiten Volladoierers (65) verbunden ist.

13. Taktrückgewinnungseinrichtung nach Anspruch 9,
**dadurch gekennzeichnet**,
daß als Addierersteuerung (73) vorgesehen ist
ein viertes ODER-Gatter (76), dessen erster Eingang mit einem Eingang (74) für negatives Stopfen (-St) und dessen zweiter Eingang mit einem Eingang (75) für positives Stopfen (+St) verbunden ist,
ein drittes D-Flipflop (77), dessen D-Eingang mit dem Ausgang des vierten ODER-Gatters (76) und dessen Takteingang mit dem Hilfstakteingang (28a) verbunden ist,
ein viertes D-Flipflop (78), dessen D-Eingang mit dem Q-Ausgang des dritten D-Flipflops (77) und dessen Takteingang mit dem Hilfstakteingang (28a) verbunden ist,
ein fünftes D-Flipflop (79), dessen D-Eingang mit dem Q-Ausgang des vierten D-Flipflops (78) und dessen Takteingang mit dem Hilfstakteingang (28a) verbunden ist,
ein fünftes Exklusiv-ODER-Gatter (80), dessen erster Eingang mit den Q-Ausgang des fünften D-Flipflops (79) und dessen zweiter Eingang mit dem Q-Ausgang des vierten D-Flipflops (78) verbunden ist,
ein sechstes D-Flipflop (81), dessen D-Eingang mit dem Ausgang des fünften Exklusiv-ODER-Gatters (80) und dessen Takteingang mit dem Hilfstakteingang (28a) verbunden ist,
ein siebentes D-Flipflop (82), dessen D-Eingang mit dem Q-Ausgang des sechsten D-Flipflops (81) und dessen Takteingang mit dem Hilfstakteingang (28a) verbunden ist,
ein achtes UND-Gatter (83), dessen erster Eingang mit dem Q-Ausgang des siebenten D-Flipflops (82) und dessen zweiter Eingang mit dem Eingang (75) für positives Stopfen verbunden ist, ein fünftes ODER-Gatter (84), dessen erster Eingang mit dem Ausgang des achten UND-Gatters (83) und dessen zweiter Eingang mit dem Ausgang des fünften Exklusiv-ODER-Gatters (80) verbunden ist,
ein neuntes UND-Gatter (85), dessen erster Eingang mit dem Ausgang des fünften ODER-Gatters (84), dessen zweiter Eingang mit dem Ausgang des vierten ODER-Gatters (76) und dessen Ausgang mit dem Ladepulseingang (52) des Anfangswert-Zählers (47) verbunden ist,
ein sechstes Exklusiv-ODER-Gatter (87), dessen erster Eingang mit den Q-Ausgang des dritten D-Flipflops (77) und dessen zweiter Eingang mit dem Q-Ausgang des fünften D-Flipflops (79) verbunden ist, und
ein zehntes UND-Gatter (86) vorgesehen ist, dessen erster Eingang mit dem Eingang (75) für positives Stopfen, dessen zweiter Eingang mit dem Ausgang des sechsten Exklusiv-ODER-Gatter (87) und dessen Ausgang mit dem Steuereingang (72) des ersten Addierers (64) verbunden ist.

## Claims

1. Process for timing recovery for received and intermediately stored data (D) which have been matched to the transmission speed by stuffing processes, and in which process the phase of an irregular write clock pulse (Tₛ) is compared with the phase of a continuous read clock pulse (T_{L}) obtained in a phase-locked loop and the frequency of the read clock pulse (T_{L}) is controlled as a function of the result of comparison with the aid of a correcting quantity (Kₑ) which is fed to a controllable oscillator (6), characterized in that there is determined from the stuffing information of the received data (D) a compensation control signal (KS) for a stuffing process (+St, -St) being performed, which stuffing process causes a sudden change in the correcting quantity (Kₑ), in that the compensation control signal (KS) is fed to a phasejump compensator (7) which determines from the correcting signal (Kₑ) fed to it an output correcting quantity (Kₐ) which controls the oscillator (6) and which firstly suppresses sudden changes in the output correcting quantity (Kₐ) and matches the output correcting quantity (Kₐ) continuously or in small steps to the correcting quantity (Kₑ).

2. Process according to Claim 1, characterized in that the phase-jump compensator (7) generates a compensation signal (EWP) which is combined with the correcting quantity (Kₑ) to form the output correcting quantity (Kₐ).

3. Process according to Claim 1, characterized in that the rate of change of the output correcting quantity (Kₐ) is determined by the correcting quantity (Kₑ) caused by stuffing processes (+St, -St).

4. Process according to Claim 1, 2 or 3, characterized in that a binary pulse-pause sequence (a1, c1, e1) is generated as the correcting quantity (Kₑ), in the event of a lengthening of a binary state (log. 1) of the correcting signal (Kₑ) by a stuffing process (+St) the leading edge of this binary state (log. 1) is firstly delayed by the compensation signal (EWP), and in the event of a shortening of the one binary state (log. 1) of the correcting signal (Kₑ) by a stuffing process (-St) the trailing edge of this binary state (log. 1) is firstly delayed by the compensation signal (EWP), so that in both cases the pulse-pause ratio remains at first at least approximately the same, and then in both cases the delay interval of the edges is reduced.

5. Timing recovery device for data (D) which are input by an irregular write clock pulse (Tₛ) into a buffer memory (10) and are read out by a continuous read clock pulse (Lₛ) generated in a phase-locked loop (PLL) containing a controllable oscillator (6) and a phase discriminator (3), characterized in that a digital oscillator (6) is provided whose frequency is controlled via the counting period of a PLL counter (27), a phase discriminator (3) having a write counter (12) and a read counter (13) is provided, from whose output signals a binary pulse-pause sequence (a1, c1, e1) is obtained as correcting quantity (Kₑ), a ramp generator (29) having an adjustable ramp counter (40) is provided, a ramp generator control device (30) is provided which during each stuffing process (+St, -St) adjusts the ramp counter (40) which transmits a compensation signal (EWP) corresponding to its counting period, which is combined via a gate network (31, 32, 33, 35) with the correcting quantity (Kₑ) of the phase discriminator (3) and transmits an output correcting signal (Kₐ) fed to the oscillator (6), and then reduces the compensation signal (EWP) in a stepwise fashion by reducing the counting period of the ramp counter (40), and after termination of the counting process transmits a final value pulse (EWP) which switches through the correcting signal (Kₑ) as output correcting signal (Kₐ) to the oscillator (6).

6. Timing recovery device according to Claim 5, characterized in that there is provided in the ramp generator control device (20) an adjustable initial value counter (47), upstream of whose adjusting inputs (49, 50, 51) a full adder (65) is connected and whose counter reading is increased or decreased during each stuffing process (+St, -St) by a constant amount, and whose counter reading determines the adjustment value (R) of the ramp counter (40) and changes said adjustment value (R) in a stepwise fashion between the stuffing processes (+St, -St).

7. Timing recovery device according to Claim 5 or 6, characterized in that connected upstream of the clock pulse input of the initial value counter (47) is a switchable divider (57) whose division ratio can be switched as a function of the counter reading (A7, A6, A5) of the initial value counter (47) and thereby effects changes of different rapidity in the compensation signal (EWP).

8. Timing recovery device according to one of Claims 5 to 7, characterized in that the ramp generator (29) is provided as a first AND gate (31), whose first input is connected to the input (4) of the phase-jump compensator (7), a first OR gate (32), whose first input is connected to the output of the first AND gate (31) and whose output is connected to the output (5) of the phase-jump compensator (7), a first NAND gate (33), whose first input is connected to a counting direction control terminal (34) and whose output is connected to the second input of the first AND gate (31), a second AND gate (35), whose first inverting input is connected to the counting direction control terminal (34) and whose output is connected to the second input of the first OR gate (32), an exclusive NOR gate (36), whose first input is connected to the input (4) of the phase-jump compensator (7) and whose second input is connected to the counting direction control terminal (34), a first D-type flip-flop (37), whose D input is connected to the output of the exclusive NOR gate (36) and whose clock pulse input is connected to an auxiliary clock pulse input (28b), a second D-type flip-flop (38), whose D input is connected to the Q output of the first D-type flip-flop (37) and whose clock pulse input is connected to the auxiliary clock pulse input (28b), a third AND gate (39), whose first input is connected to the output of the exclusive NOR gate (36) and whose second input is connected to the Q output of the second D-type flip-flop (38), and a ramp counter (40), whose output is connected to a third inverting input of the third AND gate (39), whose inverting set input is connected to the output of the exclusive NOR gate (36), whose preparatory input is connected both to the output of the third AND gate (39) and to the second input of the NAND gate (33) and to the second input of the second AND gate (35), whose clock pulse input is connected to the auxiliary clock pulse input (28b) and whose starting value input is connected to a starting value bus (41).

9. Timing recovery device according to one of Claims 5 to 8, characterized in that the ramp generator control device (30) is provided as an 8-bit initial value counter (47), whose counting direction control terminal (34) is connected to a counting direction control circuit (53) and to the ramp generator (29), whose ramp clock pulse input (48) is connected to a ramp clock pulse control circuit (56), whose three charging inputs (49, 50, 51) are connected to outputs of an adder (64) for the three most significant bits, whose charging pulse input (52) is connected to an adder control (73), whose eight outputs are connected to a first bus (43), and whose three secondary outputs (86a, 87a, 88a) for the three most significant bits (A7, A6, A5) of the counter reading are connected to the counting direction control circuit (53), the ramp clock pulse control circuit (56) and the adder (64), a first full adder (45), whose eight first inputs are connected via a first bus (43) to the eight outputs of the initial value counter (47), and whose three second inputs for the three most significant bits of a binary number up to 64 are connected to a second bus (46), and a multiplexer (42), whose first inputs are connected to the first bus (43), whose second inverting inputs are connected via a third bus (44) to the eight outputs of the first full adder (45), whose control input is connected to the counting direction control terminal (34), and whose eight outputs are connected to the starting value bus (41).

10. Timing recovery device according to Claim 9, characterized in that the counting direction control circuit (53) is provided as a fourth AND gate (54), whose first inverting input is connected to the first secondary output (86b) of the initial value counter (47) and whose output is connected to the counting direction control terminal (34), and a fifth AND gate (55) is provided, whose first input is connected to the second secondary output (87b) of the initial value counter (47), whose second input is connected to the third secondary output (88b) of the initial value counter (47), and whose output is connected to the second inverting input of the fourth AND gate (54).

11. Timing recovery device according to Claim 9, characterized in that the ramp clock pulse control circuit (56) is provided as a switchable 3:1/1:1 divider, which has a ramp auxiliary clock pulse input (58) and a changeover signal input (59), a second OR gate (60), whose output is connected to the changeover signal input (59), a sixth AND gate (61), whose first input is connected to the first secondary output (88c) of the initial value counter (47) and whose output is connected to the first input of the OR gate (60), a third OR gate (62), whose first input is connected to the second secondary output (89c) of the initial value counter (47), whose second input is connected to the third secondary output (90c) of the initial value counter (47) and whose output is connected to the second input of the sixth AND gate (61), and a seventh AND gate (63), whose first inverting input is connected to the first secondary output (88d) of the initial value counter (47), whose second inverting input is connected to the second secondary output (89d) of the initial value counter (47), whose third inverting input is connected to the third secondary output (90d) of the initial value counter (47) and whose output is connected to the second input of the second OR gate (60).

12. Timing recovery device according to Claim 9, characterized in that the adder (64) is provided as a second full adder (65), whose output is connected to the three charging inputs (49, 50, 51) of the initial value counter (47) and whose first input (88e, 89e, 90e) is connected to the secondary outputs (88a, 89a, 90a) of the initial value counter (47), a fourth exclusive OR gate (68), whose first input is connected to the control input (72), whose second input is connected to a third adder input (71) and whose output is connected to the first secondary output (88a) of the initial value counter (47), a third exclusive OR gate (67), whose first input is connected to the control input (72), whose second input is connected to a second adder input (70) and whose output is connected to the second secondary output (89a) of the initial value counter (47), and a second exclusive OR gate (66) is provided, whose first input is connected to the control input (72), whose second input is connected to a first adder input (69) and whose output is connected to the third secondary output (90a) of the initial value counter (47) of the second full adder (65).

13. Timing recovery device according to Claim 9, characterized in that the adder control (73) is provided as a fourth OR gate (76), whose first input is connected to an input (74) for negative stuffing (-St) and whose second input is connected to an input (75) for positive stuffing (+St), a third D-type flip-flop (77), whose D input is connected to the output of the fourth OR gate (76) and whose clock pulse input is connected to the auxiliary clock pulse input (28a), a fourth D-type flip-flop (78), whose D input is connected to the Q output of the third D-type flip-flop (77) and whose clock pulse input is connected to the auxiliary clock pulse input (28a), a fifth D-type flip-flop (79), whose D input is connected to the Q output of the fourth D-type flip-flop (78) and whose clock pulse input is connected to the auxiliary clock pulse input (28a), a fifth exclusive OR gate (80), whose first input is connected to the Q output of the fifth D-type flip-flop (79) and whose second input is connected to the Q output of the fourth D-type flip-flop (78), a sixth D-type flip-flop (81), whose D input is connected to the output of the fifth exclusive OR gate (80) and whose clock pulse input is connected to the auxiliary clock pulse input (28a), a seventh D-type flip-flop (82), whose D input is connected to the Q output of the sixth D-type flip-flop (81) and whose clock pulse input is connected to the auxiliary clock pulse input (28a), an eighth AND gate (83), whose first input is connected to the Q output of the seventh D-type flip-flop (82) and whose second input is connected to the input (75) for positive stuffing, a fifth OR gate (84), whose first input is connected to the output of the eighth AND gate (83) and whose second input is connected to the output of the fifth exclusive OR gate (80), a ninth AND gate (85), whose first input is connected to the output of the fifth OR gate (84), whose second input is connected to the output of the fourth OR gate (76) and whose output is connected to the charging pulse input (52) of the initial value counter (47), a sixth exclusive OR gate (87), whose first input is connected to the Q output of the third D-type flip-flop (77) and whose second input is connected to the Q output of the fifth D-type flip-flop (79), and a tenth AND gate (86) is provided, whose first input is connected to the input (75) for positive stuffing, whose second input is connected to the output of the sixth exclusive OR gate (87) and whose output is connected to the control input (72) of the first adder (64).

## Revendications

1. Procédé de récupération de la cadence pour des données (D) reçues et mémorisées temporairement, qui ont été adaptées, au moyen d'opérations de bourrage, à la vitesse de transmission, et selon lequel la phase d'une cadence irrégulière d'enregistrement (T_{S}) est comparée à la phase d'une cadence continue de lecture (T_{L}) obtenue dans un circuit de régulation de phase, et la fréquence de la cadence de lecture (T_{L}) est commandée en fonction du résultat de la comparaison, à l'aide d'une grandeur de correction (Kₑ) qui est envoyée à un oscillateur commandable (6), caractérisé par le fait
qu'à partir de l'information de bourrage des données reçues (D) est déterminé un signal de commande de compensation (KS) pour l'opération de bourrage en cours (+St, -St), signal de commande qui provoque une modification brusque de la grandeur de correction (Kₑ),
que le signal de commande de compensation (KS) est envoyé à un compensateur de sauts de phase (7), qui, à partir du signal de correction (Kₑ) qui lui est envoyé, détermine une grandeur de correction de sortie (Kₐ) qui commande l'oscillateur (6) et qui supprime des modifications tout d'abord brusques de la grandeur de correction de sortie (Kₐ) et adapte la grandeur de correction de sortie (Kₐ), continûment ou selon de petits pas, à la grandeur de correction (Kₑ).

2. Procédé suivant la revendication 1, caractérisé par le fait que le compensateur de saints de phase (7) produit un signal de compensation (E̅W̅P̅), qui est réuni à la grandeur de correction (Kₑ) pour former la grandeur de correction de sortie (Kₐ).

3. Procédé suivant la revendication 1, caractérisé par le fait que la vitesse de variation de la grandeur de correction de sortie (Kₐ) est déterminée par la grandeur de correction (Kₑ) provoquée par des opérations de bourrage (+St, -St).

4. Procédé suivant la revendication 1, 2 ou 3, caractérisé par le fait
qu'une suite binaire d'impulsions/pauses entre impulsions (a1, c1, e1) est produite en tant que grandeur de correction (Kₑ),
que dans le cas d'un allongement de l'état binaire (1 logique) du signal de correction (Kₑ) au moyen d'une opération de bourrage (+St), le flanc avant de cet état binaire (1 logique) est tout d'abord retardé par le signal de compensation (E̅W̅P̅), et
que dans le cas d'un raccourcissement d'un état binaire (1 logique) du signal de correction (Kₑ) au moyen d'une opération de bourrage (-St), le flanc arrière de cet état binaire (1 logique) est tout d'abord retardé par le signal de compensation (E̅W̅P̅), de sorte que dans les deux cas, le rapport impulsion/pause entre impulsions reste tout d'abord au moins approximativement identique, puis, dans les deux cas, le retard des flancs est réduit.

5. Dispositif de récupération de la cadence pour des données (D), qui sont enregistrées dans une mémoire tampon (10) avec une cadence irrégulière d'enregistrement (T_{S}) et sont lues avec une cadence de lecture (L_{S}) qui est produite dans une boucle de régulation de phase (PLL) comportant un oscillateur commandable (6) et un discriminateur de phase (3), caractérisé par le fait
qu'il est prévu un oscillateur numérique (6), dont la fréquence est commandée par l'intermédiaire de la durée de la période de comptage d'un compteur (27) de la boucle PLL,
qu'il est prévu un discriminateur de phase (3) comportant un compteur d'enregistrement (12) et un compteur de lecture (13), à partir des signaux de sortie desquels on obtient, en tant que grandeur de correction (Kₑ), une succession binaire d'impulsions/pauses entre impulsions (a1, c1, e1),
qu'il est prévu un générateur de signaux en rampe (29) comportant un compteur réglable de signaux en rampe (40),
qu'il est prévu un dispositif (30) de commande du générateur de signaux en rampe, qui, lors de chaque opération de bourrage (+St, -St), règle le compteur de signaux en rampe (40), qui délivre un signal de compensation (E̅W̅P̅), qui correspond à sa durée de comptage et qui est réuni, par l'intermédiaire d'un réseau de portes (31, 32, 33, 35), à la grandeur de correction (Kₑ) du discriminateur de phase (3), et qui délivre un signal de correction de sortie (Kₐ) envoyé à l'oscillateur (6) et ensuite réduit pas-à-pas le signal de compensation (E̅W̅P̅), moyennant une réduction de la durée de comptage de signaux en rampe (40), et, à la fin de l'opération de comptage, délivre une impulsion de valeur finale (EWP), qui provoque la transmission du signal de correction (Kₑ) en tant que signal de correction de sortie (Kₐ) à l'oscillateur (6).

6. Dispositif de récupération de la cadence suivant la revendication 5, caractérisé par le fait que dans le dispositif (20) de commande du générateur de signaux en rampe est prévu un compteur réglable (47) d'une valeur de départ, en amont des entrées de réglage (49, 50, 51) duquel est branché un additionneur complet (65) et dont l'état de comptage est accru ou réduit d'une valeur constante lors de chaque opération de bourrage (+St, -St) et dont l'état de comptage détermine la valeur de réglage (R) du compteur de signaux en rampe (40) et modifie pas-à-pas cette valeur de réglage (R) entre les opérations de bourrage (+St, -St).

7. Dispositif de récupération de la cadence suivant la revendication 5 ou 6, caractérisé par le fait qu'en amont de l'entrée de cadence du compteur (47) de la valeur de départ est branché un diviseur commutable (57), dont le rapport de division peut être commuté en fonction de l'état de comptage (A7, A6, A5) du compteur (47) de la valeur de départ et réalise de ce fait des modifications du signal de compensation (E̅W̅P̅), ) des vitesses différentes.

8. Dispositif de récupération de la cadence suivant l'une des revendications 5 à 7, caractérisé par le fait
qu'il est prévu, en tant que générateur de signaux en rampe (29),
une première porte ET (31), dont la première entrée est reliée à l'entrée (4) du compensateur de saints de phase (7),
une première porte OU (32), dont la première entrée est reliée à la sortie de la première porte ET (31) et dont la sortie est reliée à la sortie (5) du compensateur de saints de phase (7),
une première porte NON-ET (33), dont la première entrée est reliée à une borne (34) de commande du sens de comptage et dont la sortie est reliée à la seconde entrée de la première porte ET (31),
une seconde porte ET (35), dont la première entrée inverseuse est reliée à la borne (34) de commande du sens de comptage et dont la sortie est reliée à la seconde entrée de la première porte OU (32),
une porte NON-OU-Exclusif (36), dont la première entrée est reliée à l'entrée (4) du compensateur de saints de phase (7) et dont la seconde entrée est reliée à la borne (34) de commande du sens de comptage,
une première bascule bistable de type D (37), dont l'entrée D est reliée à la sortie de la porte NON-OU-Exclusif (36) et dont l'entrée de cadence est reliée à une entrée de cadence auxiliaire (28b),
une seconde bascule bistale de type D (38), dont l'entrée D est reliée à la sortie Q de la première bascule bistable de type D (37) et dont l'entrée de cadence est reliée à l'entrée de cadence auxiliaire (28b),
une troisième porte ET (34), dont la première entrée est reliée à la sortie de la porte NON-OU-Exclusif (36) et dont la seconde entrée est reliée à la sortie Q de la seconde bascule bistable de type D (38), et
un compteur de signaux en rampe (40), dont la sortie est reliée à une troisième entrée inverseuse de la troisième porte ET (39), dont l'entrée inverseuse de positionnement est reliée à la sortie de la porte NON-OU-Exclusif (36), dont l'entrée de préparation est connectée aussi bien à la sortie de la troisième porte ET (39) qu'à la seconde entrée de la porte NON-ET (33) ainsi que, également, à la seconde entrée de la seconde porte ET (35), dont l'entrée de cadence est reliée à l'entrée de cadence auxiliaire (28b) et dont l'entrée de la valeur de départ est reliée au bus (41) de transmission de la valeur de départ.

9. Dispositif de récupération de la cadence suivant l'une des revendications 5 à 8, caractérisé par le fait qu'il est prévu, en tant que dispositif (30) de commande du générateur de signaux en rampe, un compteur (47) de la valeur de départ à 8 bits, dont la borne (34) de commande du sens de comptage est reliée à un circuit (53) de commande du sens de comptage et au générateur de signaux en rampe (29), dont l'entrée (48) de la cadence des signaux en rampe est reliée à un circuit (56) de commande de la cadence des signaux en rampe, et dont trois entrées de charge (49, 50, 51) sont reliées à des sorties d'un additionneur (64) pour les trois bits de poids maximum, et dont l'entrée (52) d'impulsions de charge est reliée à une unité de commande d'additionneur (73), et dont huit sorties sont reliées à un premier bus (43) et dont trois sorties secondaires (86a, 87a, 88a) pour les trois bits de poids maximum (A7, A6, A5) de l'état du compteur sont reliées au circuit (53) de commande du sens de comptage, au circuit (56) de commande de la cadence des signaux en rampe et à l'additionneur (64), et qu'il est prévu un premier additionneur complet (45), dont les huit premières entrées sont reliées par l'intermédiaire d'un premier bus, (43) aux huit sorties du compteur (47) de la valeur de départ et dont trois secondes entrées pour les trois bits de poids maximum d'un nombre binaire allant jusqu'à 64, sont réunis à un second bus (46), et
un multiplexeur (42), dont les premières entrées sont reliées au premier bus (43), dont les secondes entrées inverseuses sont reliées, par l'intermédiaire d'un troisième bus (44), aux huit sorties du premier additionneur complet (45), et dont l'entrée de commande est reliée à la borne (34) de commande du sens de comptage et dont huit sorties sont reliées au bus (41) de transmission de la valeur de départ.

10. Dispositif de récupération de la cadence suivant la revendication 9, caractérisé par le fait qu'il est prévu, comme circuit (53) de commande du sens de comptage, une quatrième porte ET (54), dont la première entrée inverseuse est reliée à la première sortie secondaire (86b) du compteur (47) de la valeur de départ et dont la sortie est reliée à la borne (34) de commande du sens de comptage, et qu'il est prévu une cinquième porte ET (65), dont la première entrée est reliée à une seconde sortie secondaire (87b) du compteur (47) de la valeur de départ, et dont la seconde entrée est reliée à la troisième sortie secondaire (88b) du compteur (47) de la valeur de départ et dont la sortie est reliée à la seconde entrée inverseuse de la quatrième porte ET (54).

11. Dispositif de récupération de la cadence suivant la revendication 9, caractérisé par le fait
qu'il est prévu, comme circuit (56) de commande de la cadence des signaux en rampe, un diviseur commutable 3:1/1:1 (57) comportant une entrée (58) pour la cadence auxiliaire des signaux en rampe et une entrée (59) pour les signaux de commutation,
une seconde porte OU (60), dont la sortie est reliée à l'entrée (53) des signaux de commutation,
une sixième porte ET (61), dont la première entrée est reliée à la première sortie secondaire (88c) du compteur (47) de la valeur de départ et dont la sortie est reliée à la première entrée de la porte OU (60),
une troisième porte OU (62), dont la première entrée est reliée à la seconde sortie secondaire (89c) du compteur (47) de la valeur de départ et dont la seconde entrée est reliée à la troisième sortie secondaire (90c) du compteur (47) de la valeur de départ et dont la sortie est reliée à la seconde entrée de la sixième porte ET (61), et
une septième porte ET (63), dont la première entrée inverseuse est reliée à la première sortie secondaire (88d) du compteur (47) de la valeur de départ et dont la seconde entrée inverseuse est reliée à la seconde sortie secondaire (89d) du compteur (47) de la valeur de départ, et dont la troisième entrée inverseuse est reliée à la troisième sortie secondaire (90d) du compteur (47) de la valeur de départ et dont la sortie est reliée à la seconde entrée de la seconde porte OU (60).

12. Dispositif de récupération de la cadence suivant la revendication 9, caractérisé par le fait qu'il est prévu, en tant qu'additionneur (64),
un second additionneur complet (65), dont la sortie est reliée aux trois entrées de charge (49, 50, 51) du compteur (47) de la valeur de départ et la première entrée (88e, 89e, 90e) est reliée aux sorties secondaires (88a, 89a, 90a) du compteur (47) de la valeur de départ,
une quatrième porte OU-Exclusif (68), dont la première entrée est reliée à l'entrée de commande (72) et dont la seconde entrée est reliée à une troisième entrée d'addition (71) et dont la sortie est reliée à la première sortie secondaire (88e) du compteur (47) de la valeur initiale,
une troisième porte OU-Exclusif (67), dont la première entrée est reliée à l'entrée de commande (72) et dont la seconde entrée est reliée à une seconde entrée (70) de l'additionneur et dont la sortie est reliée à la seconde sortie secondaire (89e) du compteur (47) de la valeur de départ, et
il est prévu une seconde porte OU-Exclusif (66), dont la première entrée est reliée à l'entrée de commande (72) et dont la seconde entrée est reliée à une première entrée (69) du second additionneur complet (65) et dont la sortie est reliée à la troisième sortie secondaire (90e) du compteur (47) de la valeur de départ.

13. Dispositif de récupération de la cadence suivant la revendication 9, caractérisé par le fait
qu'il est prévu, comme unité de commande (73) de l'additionneur,
une quatrième porte OU (76), dont la première entrée est reliée à une entrée (74) pour un bourrage négatif (-St) et dont la seconde entrée est reliée à une entrée (75) pour un bourrage positif (+St),
une troisième bascule bistable de type D (77), dont l'entrée D est reliée à la sortie de la quatrième porte OU (76) et dont l'entrée de cadence est reliée à l'entrée de cadence auxiliaire (28a),
une quatrième bascule bistable de type D (78), dont l'entrée D est reliée à la sortie Q de la troisième bascule bistable de type D (77) et dont l'entrée de cadence est reliée à l'entrée de cadence auxiliaire (28a),
une cinquième bascule bistable de type D (79), dont l'entrée D est reliée à la sortie Q de la quatrième bascule bistable de type D (78) et dont l'entrée de cadence est reliée à l'entrée de cadence auxiliaire (28a),
une cinquième porte OU-Exclusif 80, dont la première entrée est reliée à la sortie Q de la cinquième bascule bistable de type D (79) et dont la seconde entrée est reliée à la sortie Q de la quatrième bascule bistable de type D (78),
une sixième bascule bistable de type D (81), dont l'entrée D est reliée à la sortie de la cinquième porte OU-Exclusif (80) et dont l'entrée de cadence est reliée à l'entrée de cadence auxiliaire (28a),
une septième bascule bistable de type D (82), dont l'entrée D est reliée à la sortie Q de la sixième bascule bistable de type D (81) et dont l'entrée de cadence est reliée à l'entrée de cadence auxiliaire (28a),
une huitième porte ET (83), dont la première entrée est reliée à la sortie Q de la septième bascule bistable de type D (82) et dont la seconde entrée est reliée à l'entrée (75) pour le bourrage positif,
une cinquième porte OU (84), dont la première entrée est reliée à la sortie de la huitième porte ET (83) et dont la seconde entrée est reliée à la sortie de la cinquième porte OU-Exclusif (80),
une neuvième porte ET (85), dont la première entrée est reliée à la sortie de la cinquième porte OU (84) et dont la seconde entrée est reliée à la sortie de la quatrième porte OU (76) et dont la sortie est reliée à l'entrée d'impulsions de charge (52) du compteur (47) de la valeur de départ,
une sixième porte OU-Exclusif (87), dont la première entrée est reliée à la sortie Q de la troisième bascule bistable de type D (77) et dont la seconde entrée est reliée à la sortie Q de la cinquième bascule bistable de type D (79), et
il est prévu une dixième porte ET (86), dont la première entrée est reliée à l'entrée (75) pour le bourrage positif, et dont la seconde entrée est reliée à la sortie de la sixième porte OU-Exclusif (87) et dont la sortie est reliée à l'entrée de commande (72) du premier additionneur (64).
